# EUROPÄISCHE PATENTSCHRIFT

(11) **EP 3 717 805 B1**
(45) Veröffentlichungstag und Bekanntmachung des Hinweises auf die Patenterteilung: **23.08.2023**
(21) Anmeldenummer: 18811242.9
(22) Anmeldetag: 28.11.2018
(51) Int. Cl.: F16J 9/26

(54) **KOLBENRING**
PISTON RING
SEGMENT DE PISTON

(30) Priorität: 30.11.2017 DE 102017221606
(43) Veröffentlichungstag der Anmeldung: 07.10.2020
(73) Patentinhaber: Federal-Mogul Burscheid GmbH, 51399 Burscheid (DE)
(72) Erfinder: STUMPF, Walter, 45259 Essen (DE); HOPPE, Steffen, 51491 Overath (DE); LAMMERS, Ralf, 42929 Wermelskirchen (DE); LINDE, Rudolf, 42929 Wermelskirchen (DE)
(74) Vertreter: Hoffmann Eitle
(86) Internationale Anmeldenummer: PCT/EP2018/082789
(87) Internationale Veröffentlichungsnummer: WO 2019/105979

(56) Entgegenhaltungen:
- EP-A1- 3 163 130
- DE-A1-102007 007 961
- DE-A1-102011 003 254
- DE-A1-102014 213 822
- DE-B3-102008 017 270
- GB-A- 2 344 150

## Beschreibung

### Technisches Gebiet

Die Erfindung betrifft einen Kolbenring.

An Kolbenringe von Verbrennungsmotoren werden hohe Anforderungen im Hinblick auf einen möglichst geringen Verschleiß und eine möglichst geringe Reibung gestellt.

### Stand der Technik

Aus der DE 10 2014 213 822 ist diesbezüglich ein Kolbenring bekannt, der insbesondere im Hinblick auf ein gutes Verschleißverhalten auf der Lauf-, mit anderen Worten der Mantelfläche, eine DLC-Schicht aufweist. Die Flankenflächen sind nitriert, können jedoch eine Beschichtung aufweisen.

Die DE 10 2007 038 188 A1 betrifft einen Kolbenring mit einer galvanischen Chromschicht, auf der eine PVD-Schicht aufgebracht ist.

Die EP 3 163 130 A1 offenbart einen Kolbenring, wobei die oberste Schicht der Lauffläche eine DLC-Schicht ist und die oberste Schicht der Flankenflächen eine Chromschicht ist.

### Darstellung der Erfindung

Vor diesem Hintergrund liegt der Erfindung die Aufgabe zugrunde, einen im Hinblick auf das Verschleißverhalten und/oder die Reibung und/oder den Herstellungsaufwand verbesserten Kolbenring zu schaffen.

Die Lösung dieser Aufgabe erfolgt durch den in Anspruch 1 beschriebenen Kolbenring.

Demzufolge weist dieser beschichtete Lauf- und Flankenflächen auf, wobei die oberste Schicht der Lauffläche eine DLC-Schicht ist, und die oberste Schicht zumindest einer Flankenfläche eine Chromschicht ist. Bevorzugt ist zumindest die untere Flankenfläche, mit anderen Worten diejenige Flankenfläche eines Kolbenrings, die dafür vorgesehen ist, von dem Brennraum abgewandt zu sein, beschichtet. Die zweite Flankenfläche kann unbeschichtet oder beschichtet, insbesondere mit einer Chromschicht versehen sein. Die DLC-Schicht auf der Lauffläche sorgt für einen geringen Verschleiß und eine vergleichsweise geringe Reibung und ist darüber hinaus brandspurfest. Die Chromschicht auf zumindest einer Flankenfläche ist, beispielsweise verglichen mit einer DLC-Schicht, einfacher und kostengünstiger aufbringbar und sorgt darüber hinaus für einen geringen Verschleiß in diesem Bereich.

Darüber hinaus wird in Verbrennungsmotoren allgemein das Thema der Reibungsverminderung immer wichtiger, wozu die Chromschicht auf zumindest einer Flankenfläche einen vorteilhaften Beitrag leistet. Infolge der Bewegung des Kolbenrings im Betrieb ergibt sich nämlich auch hier Axial- und/oder Radialreibung, für die erwartet wird, dass sie mit der erfindungsgemäßen Chromschicht vergleichsweise gering ausfällt. Ferner ergibt sich verglichen mit nitrierten Flanken der Vorteil eines geringeren Verschleißes sowohl der Flankenflächen des Kolbenrings als auch der Kolbenringnut, insbesondere bei hoher Belastung und/oder ungünstigen Schmierbedingungen. Bei Versuchen konnte mit einem Stahlkolben für die erfindungsgemäße Chrombeschichtung verglichen mit nitriertem Chromstahl ein um mehr als 50% verringerter Verschleiß und eine deutlich verringerte Reibung festgestellt werden.

Der verringerte Verschleiß ist auch im Hinblick auf das sogenannte blow-by, mit anderen Worten einem ungewollten Ölstrom an dem Ölabstreifring vorbei, relevant. Ein hoher Verschleiß der Unterflanken von Kolbenringen in der ersten Nut verursacht nämlich ein erhöhtes blow-by. Wenn dieses die Ölabscheidewirkung der Motorentlüftung übersteigt, wird über den blow-by-Strom Öl aus dem Kurbelgehäuse transportiert, und der Ölverbrauch des Motors steigt in unzulässiger Weise an. Ferner kann sich der Kolbenring in der Nut bei zu hohem Verschleiß der Flankenflächen mit der Lauffläche nach unten bei Belastung verdrehen, so dass die untere Kante der Lauffläche Öl schlechter abstreift, und der Ölverbrauch ansteigt. Schließlich kann bei einem extremen Verschleiß der Flankenflächen, gegebenenfalls in Kombination mit einem Verschleiß der Kolbenringnut, der Kolbenring aufgrund eines zu hohen axialen Spiels in der Nut brechen.

Bevorzugte Weiterbildungen des erfindungsgemäßen Kolbenrings gehen aus den weiteren Ansprüchen hervor.

Für die DLC-Schicht werden besonders günstige Eigenschaften erwartet, wenn sie wasserstofffrei ist, in bestimmten Anwendungsfällen kann jedoch auch eine wasserstoffhaltige DLC-Schicht vorteilhaft sein.

Nachdem es prozesstechnisch Vorteile bietet, die Chromschicht zuerst auszubilden, kann die DLC-Schicht wie in der Erfindung bereichsweise auf einer Chromschicht ausgebildet sein. Dies gilt sowohl für Lauf- als auch Flankenflächen.

Insbesondere bietet es für die Herstellung Vorteile , dass erfindungsgemäß die DLC-Schicht die Chromschicht im Bereich der Umfangskanten zumindest teilweise überlappt. Hierbei läuft die Chromschicht zu der Umfangskante hin aus. Die Umfangskanten können ferner unter einem definierten Winkel bearbeitet sein.

Im Hinblick auf die Ausbildung der DLC-Schicht wird ein PVD (Physical Vapour Deposition)-Verfahren bevorzugt.

Besondere Vorteile, insbesondere im Hinblick auf einen geringen Verschleiß werden erwartet, wenn die Chromschicht eine Härte von mindestens 800 HV 0,1 aufweist.

Für die Rissnetzdichte der Chromschicht wird insbesondere im Hinblick auf die möglichen Partikeleinlagerungen bevorzugt, dass diese eine Rissrate von 700 bis 1200 Risse/cm aufweist.

Im Hinblick auf eine konkrete Verringerung der Reibung im Bereich der Flankenflächen wird für die Chromschicht ein Reibkoeffizient im geschmierten Reibkontakt bevorzugt, der zumindest 20% geringer ist als der von nitriertem Chromstahl.

Aufgrund günstiger Erfahrungen wird für die Herstellung der Chromschicht eine galvanische Ausbildung bevorzugt.

Insbesondere kann hierbei eine Bearbeitung der Chromschicht, bevorzugt kombiniert mit einer galvanischen Aufbringung, derart erfolgen, dass die Rauheit der Flankenflächen nachfolgend geringer als Rz 4 ist.

Zur weiteren Verbesserung ihrer Eigenschaften, kann die Chromschicht Partikeleinlagerungen aufweisen, die insbesondere in das Rissnetzwerk der Chromschicht eingelagert sein können.

Die Lösung der oben genannten Aufgabe erfolgt ferner durch das im Anspruch 7 beschriebene Verfahren, das im Hinblick auf seine Verfahrensschritte dem erfindungsgemäß gestalteten Kolben entspricht. Es sei an dieser Stelle erwähnt, dass sämtliche vorangehend und nachfolgend angegebene Verfahrensschritte für den erfindungsgemäßen Kolbenring ebenfalls bevorzugt werden, und umgekehrt.

Insbesondere bietet es für den Prozessablauf Vorteile, wenn die Chromschicht, insbesondere galvanisch, vor der DLC-Schicht ausgebildet wird. Hierdurch können Probleme im Hinblick auf die schlechte Leitfähigkeit von DLC, die das galvanische Verfahren behindern würde, im Hinblick auf eine unerwünschte Wasserstoffgasbildung beim Verchromen und die chemische Aggressivität des Chrom-Elektrolyten gegenüber DLC vermieden werden.

### Kurze Beschreibung der Zeichnungen

Nachfolgend wird ein in den Zeichnungen dargestelltes Ausführungsbeispiel der Erfindung näher erläutert.
Fig. 1 zeigt einen Querschnitt durch einen erfindungsgemäßen Kolbenring.
Fig. 2 zeigt den in Fig. 1 gekennzeichneten Bereich in vergrößertem Maßstab.

### Ausführliche Beschreibung einer bevorzugten Ausführungsform der Erfindung

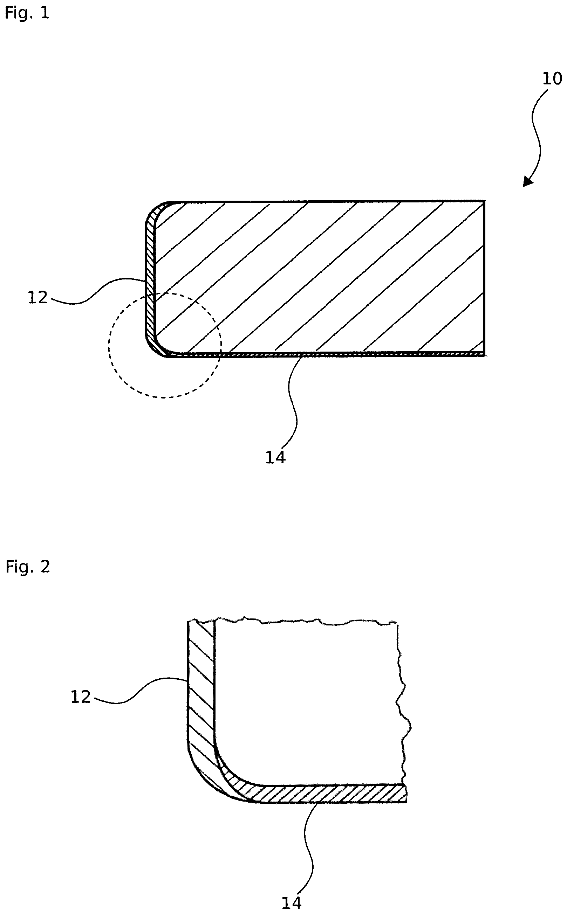

Wie in der Fig. 1 zu erkennen ist, weist ein Kolbenring 10 typischerweise einen rechteckigen Querschnitt mit einer Lauffläche 12 und hierzu im Wesentlichen senkrecht verlaufenden Flankenflächen auf, von denen die untere Flankenfläche mit 14 bezeichnet ist. Bei dem gezeigten bevorzugten Ausführungsbeispiel ist die untere Flankenfläche 14 mit einer Chromschicht, und die Lauffläche mit einer DLC-Schicht versehen. Hierbei ist die Maßnahme gezeigt, wonach die DLC-Schicht die Chromschicht insbesondere in dem Übergangsbereich zwischen Lauf- 12 und Flankenfläche 14 überlappt. Bei dem gezeigten Beispiel ist der Übergang gerundet ausgeführt, er kann jedoch ebenso schräg sein.

Wie insbesondere in Fig. 2 zu erkennen ist, erstreckt sich die Chromschicht mit abnehmender Dicke bis zu der (in den Figuren vertikalen) Lauffläche 12, und die DLC-Schicht ebenfalls mit abnehmender Dicke in etwa bis zu dem Beginn der (in den Figur horizontalen) Flankenfläche 14.

## Patentansprüche

1. Kolbenring (10) mit zumindest einer Lauffläche (12) und Flankenflächen (14), die beschichtet sind, wobei die oberste Schicht der Lauffläche (12) eine wasserstoffhaltige oder wasserstofffreie DLC-Schicht ist, **dadurch gekennzeichnet, dass** die oberste Schicht zumindest einer, bevorzugt der unteren, Flankenfläche (14) eine Chromschicht ist, wobei sich zumindest bereichsweise unterhalb der DLC-Schicht eine Chromschicht befindet, wobei die DLC-Schicht die Chromschicht im Bereich der Umfangskanten zumindest teilweise überlappt und wobei die Chromschicht zu der Umfangskante hin ausläuft.

2. Kolbenring (10) nach Anspruch 1, **dadurch gekennzeichnet, dass** die DLC-Schicht wasserstofffrei ist.

3. Kolbenring (10) nach einem der vorangehenden Ansprüche, **dadurch gekennzeichnet, dass** die DLC-Schicht durch ein PVD-Verfahren ausgebildet ist.

4. Kolbenring (10) nach einem der vorangehenden Ansprüche, **dadurch gekennzeichnet, dass** die Chromschicht eine Härte von mindestens 800 HV 0,1, aufweist.

5. Kolbenring (10) nach einem der vorangehenden Ansprüche, **dadurch gekennzeichnet, dass** die Chromschicht eine Rissnetzdichte mit einer Rissrate von 700 bis 1200 Risse/cm aufweist.

6. Kolbenring (10) nach einem der vorangehenden Ansprüche, **dadurch gekennzeichnet, dass** ein Reibkoeffizient der Chromschicht im geschmierten Reibkontakt um mindestens 20% geringer ist als der von nitriertem Chromstahl.

7. Kolbenring (10) nach einem der vorangehenden Ansprüche, **dadurch gekennzeichnet, dass** die Chromschicht galvanisch ausgebildet ist.

8. Kolbenring (10) nach einem der vorangehenden Ansprüche, **dadurch gekennzeichnet, dass** die Flankenfläche (14) eine Rauheit von kleiner als Rz 4 aufweist.

9. Kolbenring (10) nach einem der vorangehenden Ansprüche, **dadurch gekennzeichnet, dass** die Chromschicht Partikeleinlagerungen aufweist.

10. Verfahren zur Herstellung eines Kolbenrings (10) gemäß einem der vorangehenden Ansprüche, bei dem als oberste Schicht der Lauffläche (12) eine DLC-Schicht, und als oberste Schicht zumindest einer Flankenfläche (14) eine Chromschicht ausgebildet wird.

11. Verfahren nach Anspruch 10, **dadurch gekennzeichnet, dass** die DLC-Schicht durch ein PVD-Verfahren ausgebildet wird.

12. Verfahren nach Anspruch 10 oder 11, **dadurch gekennzeichnet, dass** die Chromschicht galvanisch ausgebildet wird.

13. Verfahren nach einem der Ansprüche 10 bis 12, **dadurch gekennzeichnet, dass** die Chromschicht vor der DLC-Schicht ausgebildet wird.

14. Verfahren nach einem der Ansprüche 10 bis 13, **dadurch gekennzeichnet, dass** die Chromschicht derart bearbeitet wird, dass sie eine Rauheit von kleiner Rz 4 aufweist.

## Claims

1. Piston ring (10) with at least one running surface (12) and flank surfaces (14) which are coated, wherein the top layer of the running surface (12) is a hydrogen-containing or hydrogen-free DLC coating, **characterised in that** the top layer of at least one, preferably the lower, flank surface (14) is a chrome layer, wherein there is, at least in some areas, a chrome layer below the DLC coating, wherein the DLC coating at least partially overlaps the chrome layer in the region of the circumferential edges and wherein the chrome layer thins out towards the circumferential edge.

2. Piston ring (10) according to claim 1, **characterised in that** the DLC coating is hydrogen-free.

3. Piston ring (10) according to one of the preceding claims, **characterised in that** the DLC coating is formed using a PVD method.

4. Piston ring (10) according to one of the preceding claims, **characterised in that** the chrome layer has a hardness of at least 800 HV 0.1.

5. Piston ring (10) according to one of the preceding claims, **characterised in that** the chrome layer has a crack mesh density with a crack rate of 700 to 1200 cracks/cm.

6. Piston ring (10) according to one of the preceding claims, **characterised in that** a coefficient of friction of the chrome layer in lubricated friction contact is at least 20% lower than that of nitrided chrome steel.

7. Piston ring (10) according to one of the preceding claims, **characterised in that** the chrome layer is formed galvanically.

8. Piston ring (10) according to one of the preceding claims, **characterised in that** the flank surface (14) has a roughness of less than Rz 4.

9. Piston ring (10) according to one of the preceding claims, **characterised in that** the chrome layer has particle intercalations.

10. Method for manufacturing a piston ring (10) according to one of the preceding claims in which a DLC coating is formed as the top layer of the running surface (12) and a chrome layer is formed as the top layer of at least one flank surface (14).

11. Method according to claim 10, **characterised in that** the DLC coating is formed using a PVD method.

12. Method according to claim 10 or 11, **characterised in that** the chrome layer is formed galvanically.

13. Method according to one of the claims 10 to 12, **characterised in that** the chrome layer is formed before the DLC coating.

14. Method according to one of the claims 10 to 13, **characterised in that** the chrome layer is finished in such a way that it has a roughness of less than Rz 4.

## Revendications

1. Segment de piston (10) avec au moins une surface de roulement (12) et des surfaces de flanc (14) qui sont revêtues, dans lequel la couche supérieure de la surface de roulement (12) est une couche DLC contenant de l'hydrogène ou exempte d'hydrogène, **caractérisé en ce que** la couche supérieure d'au moins une surface de flanc (14), de préférence la surface de flanc inférieure, est une couche de chrome, dans lequel une couche de chrome se trouve au moins par zones en dessous de la couche DLC,
dans lequel la couche DLC recouvre au moins partiellement la couche de chrome dans la zone des bords périphériques, et dans lequel la couche de chrome se termine vers le bord périphérique.

2. Segment de piston (10) selon la revendication 1, **caractérisé en ce que** la couche DLC est exempte d'hydrogène.

3. Segment de piston (10) selon l'une quelconque des revendications précédentes, **caractérisé en ce que** la couche DLC est réalisée par un procédé PVD.

4. Segment de piston (10) selon l'une quelconque des revendications précédentes, **caractérisé en ce que** la couche de chrome présente une dureté d'au moins 800 HV 0,1.

5. Segment de piston (10) selon l'une quelconque des revendications précédentes, **caractérisé en ce que** la couche de chrome présente une densité de réseau de fissures avec un taux de fissures de 700 à 1200 fissures/cm.

6. Segment de piston (10) selon l'une quelconque des revendications précédentes, **caractérisé en ce qu'**un coefficient de frottement de la couche de chrome en contact de frottement lubrifié est inférieur d'au moins 20 % à celui de l'acier au chrome nitruré.

7. Segment de piston (10) selon l'une quelconque des revendications précédentes, **caractérisé en ce que** la couche de chrome est réalisée par galvanisation.

8. Segment de piston (10) selon l'une quelconque des revendications précédentes, **caractérisé en ce que** la surface de flanc (14) présente une rugosité inférieure à Rz 4.

9. Segment de piston (10) selon l'une quelconque des revendications précédentes, **caractérisé en ce que** la couche de chrome présente des incrustations de particules.

10. Procédé de fabrication d'un segment de piston (10) selon l'une quelconque des revendications précédentes, dans lequel une couche DLC est réalisée comme couche supérieure de la surface de roulement (12), et une couche de chrome comme couche supérieure d'au moins une surface de flanc (14).

11. Procédé selon la revendication 10, **caractérisé en ce que** la couche DLC est réalisée par un procédé PVD.

12. Procédé selon la revendication 10 ou 11, **caractérisé en ce que** la couche de chrome est réalisée par galvanisation.

13. Procédé selon l'une quelconque des revendications 10 à 12, **caractérisé en ce que** la couche de chrome est réalisée avant la couche DLC.

14. Procédé selon l'une quelconque des revendications 10 à 13, **caractérisé en ce que** la couche de chrome est traitée de manière à présenter une rugosité inférieure à Rz 4.
